(19) Europäisches Patentamt
European Patent Office
Office européen des brevets

(11) **EP 2 128 899 A1**

(12) **EUROPÄISCHE PATENTANMELDUNG**

(43) Veröffentlichungstag:
**02.12.2009 Patentblatt 2009/49**

(51) Int Cl.:
*H01L 21/768* (2006.01)

(21) Anmeldenummer: **09170565.7**

(22) Anmeldetag: **20.11.2003**

| | |
|---|---|
| (84) Benannte Vertragsstaaten:<br>**DE FR**<br><br>(30) Priorität: **23.11.2002 DE 10254815**<br><br>(62) Dokumentnummer(n) der früheren Anmeldung(en) nach Art. 76 EPÜ:<br>**03767441.3 / 1 563 534**<br><br>(71) Anmelder: **Infineon Technologies AG**<br>**85579 Neubiberg (DE)**<br><br>(72) Erfinder:<br>• **Bradl, Stephan**<br>**93051 Regensburg (DE)** | • **Kerkel, Klaus**<br>**93073 Neutraubling (DE)**<br>• **Lindner, Christine**<br>**90602 Pyrbaum (DE)**<br><br>(74) Vertreter: **Karl, Frank**<br>**Kindermann Patentanwälte**<br>**Postfach 100234**<br>**85593 Baldham (DE)**<br><br>Bemerkungen:<br>Diese Anmeldung ist am 17-09-2009 als Teilanmeldung zu der unter INID-Code 62 erwähnten Anmeldung eingereicht worden. |

(54) **Verfahren zum galvanischen Aufbringen eines Metalls, insbesondere von Kupfer, Verwendung dieses Verfahrens und integrierte Schaltungsanordnung**

(57) Erläutert wird unter anderem ein Verfahren, bei dem ein Kontaktloch (18) zu einer Leitbahn (14) in einer Isolierschicht (16) hergestellt wird. Anschließend wird eine Barriereschicht (20) aufgebracht. Danach wird eine Fotolackschicht (30) aufgebracht, bestrahlt und entwickelt. Mit Hilfe eines galvanischen Verfahrens wird danach ein Kupferkontakt (32) in dem Kontaktloch (18) erzeugt. Entweder dient die Barriereschicht (20) oder eine zusätzliche Grenzelektrodenschicht (22) als Grenzelektrode in dem galvanischen Prozess. Kritische Metallkontaminationen werden durch dieses Verfahren in der Fertigung gering gehalten.

FIG 1B

**Beschreibung**

Die Erfindung betrifft ein Verfahren zum Aufbringen von Metall oder einer Metalllegierung bei der Herstellung einer integrierten Schaltungsanordnung. Bei dem Verfahren werden in einer Isolierschicht einer integrierten Schaltungsanordnung eine Vielzahl von Kontaktlöchern zu Leitbahnen einer Metallisierungsschicht erzeugt. Anschließend wird eine Barriereschicht aufgebracht, beispielsweise aufgesputtert.

Das Kontaktloch wird auch als Via bezeichnet, wenn es nicht unmittelbar bis zu einem Halbleiterträgersubstrat der integrierten Schaltungsanordnung führt. Das Kontaktloch hat bspw. einen Durchmesser, der wesentlich kleiner als 1 μm ist (Mikrometer) oder der größer als 1 μm oder sogar größer als 10 μm ist.

Die Barriereschicht dient bspw. zur Verbesserung der Haftung zwischen dem Metall und der Isolierschicht. Außerdem dient die Barriereschicht bspw. als Diffusionssperre für die Atome des Metalls. Es soll verhindert werden, dass Atome auf Grund ihres großen Diffusionskoeffizienten bis in aktive Bereiche des Halbleiterträgersubstrats vordringen und dort die elektrischen Eigenschaften von integrierten Halbleiterbauelementen ungewollt verändern.

Es ist Aufgabe der Erfindung, ein einfaches Verfahren zum Aufbringen eines Metalls anzugeben, insbesondere von Kupfer oder einer Kupferlegierung. Außerdem sollen Verwendungen des Verfahrens und eine integrierte Schaltungsanordnung angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass steigende Anforderungen an die Leistungsfähigkeit von Halbleiterchips zu immer größeren Packungsdichten bei gleichzeitig immer höheren Stromdichten in den Metallisierungsebenen bzw. Metallisierungslagen der integrierten Schaltungsanordnung führen, insbesondere bei sogenannten Leistungshalbleitern, mit denen mehrere Ampere zu schalten sind. Probleme durch Elektromigration und durch Erwärmung treten in den Vordergrund und limitieren die Leistungsfähigkeit der Bauelemente. Einen Ausweg stellt z.B. die Verwendung von Kupfer oder von Kupferlegierungen an Stelle von Wolfram bzw. Aluminium dar. Kupfer ermöglicht im Vergleich zu den genannten Werkstoffen höhere Stromdichten und eine um den Faktor 2 bessere Wärmeleitfähigkeit. Aufgrund seines hohen Diffusionskoeffizienten im Silizium stellt Kupfer jedoch auch gleichzeitig ein erhebliches Risiko für alle Transistorebenen dar. Durch eine Diffusion von Kupferatomen in die aktiven Bereiche verändert sich beispielsweise die Einsatzspannung, die Kanallänge bzw. die Schaltzeit eines Transistors.

Mit anderen Worten ausgedrückt, wirken die diffundierten Atome bspw. als:

- Störstelle,
- Zentrum für Ladungsträger Generation oder Rekombination,
- Ursache für die Verkürzung der Lebensdauer von Ladungsträgern, und/oder
- Keime für oxidationsinduzierte Stapelfehler und Schwachstellen in dünnen Oxidschichten.

Selbst ein Ausfall eines Transistors ist möglich. Demzufolge muss die Diffusion von Kupferatomen bzw. anderen Atome mit großem Diffusionskoeffizienten in Silizium unterbunden werden. Dazu ist die Barriereschicht allein nicht ausreichend, weil auch eine Kupfer-Querkontamination innerhalb der Produktionslinie verhindert werden muss.

Die Erfindung geht deshalb weiterhin von der Überlegung aus, dass in einer Halbleiterfertigung, in der bspw. Kupfer, in den Metallisierungsebenen verwendet wird, streng zwischen der sogenannten FEOL-Fertigung (Front End of Line) und der sogenannten BEOL-Fertigung (Back End of Line) getrennt werden muss. Dabei betrifft die FEOL-Fertigung u.a. Verfahrensschritte zum Herstellen von STI (Shallow Trench Isolation), von LOCOS-Isolationen (LOCal Oxidization of Silicon), die Herstellung von Transistoren, einschließlich der erforderlichen Implantationen. Die BEOL-Fertigung betrifft u.a. die Herstellung von Metallisierungs- und Passivierungsebenen. Wird beispielsweise nur die letzte Metallisierungslage unter Verwendung eines Metalls, dessen Atome in Silizium einen großen Diffusionskoeffizienten haben, hergestellt, so wird die BEOL-Fertigung nochmals in zwei Teilbereiche unterteilt. Die Unterteilung führt zu einer anlagentechnischen Dedizierung. Das bedeutet, dass eine kontaminierte Anlage nicht für Prozesse verwendet werden darf, bei denen eine Querkontamination zwischen verschiedenen Anlagen kritisch ist. Häufig muss diese Anlage sogar räumlich von anderen Produktionsbereichen getrennt werden.

Beim erfindungsgemäßen Verfahren werden zusätzlich zu den eingangs genannten Verfahrensschritten ohne Beschränkung durch die angegebene Reihenfolge die folgenden Verfahrensschritte ausgeführt:

- Aufbringen eines Metalls oder einer Metalllegierung mit Hilfe eines galvanischen Verfahrens,
- wobei bei einer ersten Alternative die Barriereschicht als Grenzelektrode in dem galvanischen Verfahren zum Aufbringen des Metalls oder der Metalllegierung dient,
- oder wobei bei einer zweiten Alternative zusätzlich zur Barriereschicht vor dem Aufbringen der strahlungsempfindlichen Schicht eine Grenzelektrodenschicht aufgebracht wird, die kein Metall enthält, dessen Atome in Silizium einen großen Diffusionskoeffizienten haben, oder die keine Metalllegierung ist, in der mehr als 5 % der Atome in Silizium einen großen Diffusionskoeffizienten haben, und die aus einem Material mit einer anderen Materialzusammensetzung als die Barriereschicht besteht.

Damit nutzt das erfindungsgemäße Verfahren eine galvanische Abscheidung des Metalls, die sich sowohl zum Abscheiden kleinerer Schichtdicken zwischen 30 nm und 300nm, mit einem außenstromlosen Verfahren oder einem Verfahren mit Außenstrom, aber auch zum Abscheiden größerer Schichtdicken eignet. So lassen sich Schichtdicken größer als 1 $\mu$m oder größer als 10 $\mu$m mit einem Verfahren mit Außenstrom oder in einem kombinierten galvanischen Verfahren erzeugen. Jedoch wird bei dem erfindungsgemäßen Verfahren eine Grenzelektrodenschicht verwendet, deren Atome in Silizium einen kleinen Diffusionskoeffizienten haben, d.h. gerade keinen großen Diffusionskoeffizienten. Dies bietet bspw. den Vorteil, dass ein lithografisches Verfahren zum Festlegen der Lage der galvanisch zu erzeugenden Metallstrukturen ggf. bis auf das Resistentfernen vollständig mit Maschinen durchführbar ist, die bei der Durchführung des Verfahrens nicht mit dem Metall kontaminiert werden, aus dem die galvanisch abgeschiedene Metallschicht besteht. Diese Anlagen stehen daher der Produktion uneingeschränkt zur Verfügung.

Bei der ersten Alternative wird die Barriereschicht als Grenzelektrodenschicht benutzt. Eine zusätzliche Grenzelektrodenschicht muss also nicht aufgebracht werden. Beim Aufbringen der Barriereschicht und der strahlungsempfindlichen Schicht treten keine Kontaminationsprobleme auf.

Bei der zweiten Alternative wird jedoch zusätzlich zur Barriereschicht eine Grenzelektrodenschicht aufgebracht. Dadurch entsteht ein Freiheitsgrad, nämlich die Wahl des Materials der Grenzelektrodenschicht. Durch das Verwenden eines geeigneten Materials lässt sich das galvanische Verfahren auf einfachere Art durchführen, als ohne Verwenden einer zusätzlichen Grenzelektrodenschicht, insbesondere hinsichtlich der Anforderungen an die Einhaltung von Prozessparametern. Damit beim Aufbringen der Grenzelektrodenschicht und beim Aufbringen weiterer Schichten, bspw. einer strahlungsempfindlichen Schicht, keine Kontaminationen auftreten, besteht die Grenzelektrodenschicht aus einem Metall, dessen Atome in Silizium einen kleinen Diffusionskoeffizienten haben, d.h. gerade keinen großen Diffusionskoeffizienten D.

Bei einer Weiterbildung werden auch folgende Schritte ausgeführt:

- Aufbringen einer strahlungsempfindlichen Schicht nach dem Aufbringen der Barriereschicht,
- Bestrahlen der strahlungsempfindlichen Schicht gemäß einem Muster,
- Entwickeln der strahlungsempfindlichen Schicht nach dem Bestrahlen,
- Aufbringen eines Metalls oder einer Metalllegierung in Bereiche, die nach dem Entwickeln frei von der strahlungsempfindlichen Schicht sind, mit Hilfe eines galvanischen Verfahrens,
- nach dem Aufbringen des Metalls oder der Metalllegierung Entfernen von Resten der strahlungsempfindlichen Schicht.

Jedoch lässt sich auch ganzflächig auf die Grenzelektrodenschicht galvanisieren, wonach dann bspw. ein CMP-Verfahren (chemisch mechanisches Polieren) ausgeführt wird.

Bei einer nächsten Weiterbildung hat jedoch das galvanisch aufzubringende Metall bzw. die galvanisch aufzubringende Metalllegierung einen großen Diffusionskoeffizienten in Silizium. Der Diffusionskoeffizient der Atome des Metalls ist bei 400°C bspw. größer als $10^{-9}$ cm$^2$/s ist. So gilt für Kupfer für eine Temperatur T im Bereich zwischen 400°C (Grad Celsius) und 900°C:

$$D[cm^2/s] \; = \; 4,7 \; 10^{-3} \; exp(- \; e_a/kT),$$

wobei $e_a$ die Aktivierungsenergie in eV (Elektronenvolt) ist, hier 0,43 eV, und k die Boltzmannkonstante ist.

Gleiches gilt für eine galvanisch aufzubringende Metalllegierung, in der mehr als 5 Gewichts-%, mehr als 50 Gewichts-% oder sogar mehr als 90 Gewichts-% der Atome in Silizium einen großen Diffusionskoeffizienten haben. Die Zusätze haben oft nur einen kleinen Anteil von bspw. kleiner als 5 Gewichts-%. Alternativ kann galvanisch jedoch auch ein anderes Metall oder eine andere Metalllegierung abgeschieden werden, z.B. aus einem Material mit einem kleinen Diffusionskoeffizienten, z.B. Aluminium. Wird auf dieses Material später ein Material mit einem großen Diffusionskoeffizienten abgeschieden, so gelten bezüglich der Kontamination die gleichen Überlegungen, wie oben erläutert.

Bei einer nächsten Weiterbildung des erfindungsgemäßen Verfahrens wird das galvanische Verfahren unter Verwendung einer äußeren Strom- oder Spannungsquelle durchgeführt. Die äußere Strom- oder Spannungsquelle führt unter anderem zu einer höheren Abscheidegeschwindigkeit. Außerdem werden dem galvanischen Bad bei einem Verfahren mit Außenstrom bspw. Reduktionsmittel und Katalysatoren zugesetzt.

Bei einer anderen Weiterbildung wird ein außenstromloses galvanisches Verfahren durchgeführt. Die Abscheiderate für einen Mikrometer Schichtdicke liegt weiterhin im Minutenbereich und ist bspw. kleiner als 10 Minuten. Jedoch werden Verzerrungen des elektrischen Feldes vermieden, wie sie bei einem Verfahren mit äußerer Strom- oder Spannungsquelle auftreten. Dadurch entsteht eine gleichmäßig dicke Metallschicht. Das sich beim außenstromlosen galvanischen Verfahren bildende Kristallgitter wird im Vergleich zu dem galvanischen Verfahren mit äußerer Strom- oder Spannungsquelle viel gleichmäßiger und aufgrund der größeren Zeit für die Abscheidung auch homogener. Dies senkt den elektrischen Widerstand der Schicht, so dass bei gleichbleibendem Stromfluss weniger Wärme erzeugt wird. Außerdem ist das homogenere Kristallgitter beständiger gegen Elektromigration. Diese technischen Eigenschaften sind um so wichtiger, je höher die zu schaltenden Stromstärken sind.

Die Erfindung betrifft in einem zweiten Aspekt auch ein Verfahren zum Aufbringen von Metall mit einem außenstromlosen galvanischen Verfahren. Die außenstromlos abgeschiedene galvanische Schicht ist besonders dicht und besonders gleichmäßig. Die dadurch verbesserten elektrischen Eigenschaften der außenstromlos abgeschiedenen galvanischen Schicht im Vergleich zu einer Abscheidung mit Außenstrom, insbesondere der geringere elektrische Widerstand und die Beständigkeit gegen Elektromigration, sind für viele Anwendungen von besonderer Bedeutung, bspw. in Kontaktlöchern, d.h. an Stellen, an denen die Stromdichte sehr hoch ist.

Bei der ersten Alternative gemäß dem Verfahren des zweiten Aspekts wird wieder die Barriereschicht als Grenzelektrodenschicht benutzt. Eine zusätzliche Grenzelektrodenschicht muss also wiederum nicht aufgebracht werden.

Bei der zweiten Alternative gemäß dem Verfahren des zweiten Aspekts wird wieder zusätzlich zur Barriereschicht eine Grenzelektrodenschicht aufgebracht. Dadurch entsteht ein Freiheitsgrad, nämlich die Wahl des Materials der Grenzelektrodenschicht. Durch das Verwenden eines geeigneten Materials lässt sich das galvanische Verfahren auf einfachere Art durchführen, als ohne Verwenden einer zusätzlichen Grenzelektrodenschicht zur Barriereschicht.

Bei einer Weiterbildung des Verfahrens gemäß zweiten Aspekt wird eine metallische Grenzelektrodenschicht verwendet, deren Atome in Silizium einen großen Diffusionskoeffizienten haben, oder eine Metalllegierungsschicht, in der mehr als 5 % der Atome in Silizium einen großen Diffusionskoeffizienten haben. Alternativ wird als Grenzelektrodenschicht eine Schicht verwendet, die keine solche Metallschicht oder keine solche Metalllegierungsschicht ist, beispielsweise eine Barriereschicht oder eine zusätzlich zur Barriereschicht aufgebrachte Grenzelektrodenschicht.

Bei einer nächsten Weiterbildung des Verfahrens gemäß erstem Aspekt oder des Verfahrens gemäß zweitem Aspekt hat das Material der Grenzelektrodenschicht in der elektrochemischen Spannungsreihe ein kleineres Potential als das galvanisch abgeschiedene Metall oder die galvanisch abgeschiedene Metalllegierung. Die elektrochemische Spannungsreihe gibt die sich einstellenden Spannungen verschiedener Materialien an, wenn diese mit einer Bezugselektrode, nämlich einer Wasserstoffelektrode, zu einer galvanischen Zelle kombiniert werden. Beispielsweise gilt:

| | |
|---|---|
| Li | - 3,04 V (Volt), |
| Al | - 1,66 V, |
| Ti | - 1,628 V, |
| Ni | - 0,23 V, |
| $H_2$ | 0 V, |
| Cu | + 0,35 V, |
| Ag | + 0,8 V, |
| Hg | + 0,85 V, |
| Pt | + 1, 2 V, |
| Au | + 1,41 V. |

Beispielsweise gilt für Kupfer Cu, dass mit wenigen Ausnahmen, z.B. für Gold Au, für Platin Pt, für Quecksilber Hg und für Silber Ag, nahezu alle Metalle im Beisein von Kupferionen oxidiert werden, wobei unedlere Metalle in Lösung gehen und sich die in Lösung befindlichen Kupferionen als metallischer Überzug niederschlagen.

Deshalb enthält bei einer Weiterbildung der erfindungsgemäßen Verfahren eine für das galvanische Verfahren verwendete Elektrolytlösung Metallionen, insbesondere Kupferionen. Die Lösung basiert bei einer Ausgestaltung auf Wasser, auf Alkohol oder auf Ether oder auf einem Gemisch aus diesen Stoffen. Weitere Zusätze sind für eine elektrochemische Abscheidung aufgrund des Potentialunterschiedes nicht erforderlich, d.h. insbesondere keine Reduktionsmittel wie z.B. Formaldehyd und auch keine Katalysatoren für eine Fällungsreaktion.

Die Elektrolytlösung enthält damit bei der Weiterbildung nur wenige Bestandteile, beispielsweise nur die Moleküle der Basislösung, z.B. Wassermoleküle, die Metallionen und Ionen entgegengesetzter Polarität, die mit den Metallionen ein Salz bilden, das in der Elektrolytlösung gelöst ist. Aufgrund der galvanischen Abscheidung durch Potentialunterschiede sind weder die Temperatur noch der pH-Wert der Elektrolytlösung bei dem außenstromlosen galvanischen Verfahren kritisch. Beispielsweise wird das Verfahren bei Zimmertemperatur, d.h. bei beispielsweise 20°C durchgeführt. Ein Erwärmen der Elektrolytlösung beschleunigt die Abscheidung, führt aber zu einem schnelleren Verdampfen des Lösungsmittels und damit zu einer Veränderung der Konzentrationen in der Elektrolytlösung. Ein Abkühlen unter die genannte Temperatur führt zu einem gleichmäßigeren Schichtwachstum, aber zu einer langsameren Abscheiderate.

Der pH-Wert der Elektrolytlösung liegt bei dem außenstromlosen Verfahren abhängig von dem verwendeten Salz im Bereich von 1 bis 6, d.h. im sauren Bereich, beispielsweise bei Verwendung von Kupfersulfat $CuSO_4$, oder im Bereich zwischen 8 bis 14, d.h. im basischen Bereich, beispielsweise bei Verwendung von Kupferhydroxid $Cu(OH)_2$.

Bei einer nächsten Weiterbildung der erfindungsgemäßen Verfahren wird die zusätzlich zur Barriereschicht aufgebrachte Grenzelektrodenschicht während des galvanischen Verfahrens vollständig oder bis zu einer Teilschicht zersetzt. Bei einer Weiterbildung wird die Barriereschicht in einer Teilschicht zersetzt. Der verbleibende Teil der Barriereschicht gewährleistet noch eine ausreichende Diffusionssperre.

Bei einer nächsten Weiterbildung der erfindungsgemäßen Verfahren wird nach dem Entfernen der strahlungsempfindlichen Schicht ein Ätzvorgang durchgeführt, bei dem die Barriereschicht gemäß den beim Galvanisieren entstandenen Metallstrukturen geätzt wird, vorzugsweise in einem einfachen nasschemischen Ätzprozess.

Bei einer anderen Weiterbildung enthält die Leitbahn Aluminium oder eine Aluminiumlegierung, beispielsweise Aluminium mit einem geringen Zusatz von Silizium oder Kupfer, z.B. von einem Gewichtsprozent. Die erfindungsgemäßen Verfahren eignen sich besonders für die Herstellung der obersten Metallisierungslage. Beispielsweise bestehen die unteren Metallisierungslagen aus Aluminium oder einer Aluminiumlegierung, die z.B. mehr als 90 Gewichts-% oder mehr als 95 Gewichts-% Aluminium enthält, d.h. aus einem gut prozessierbaren Material.

Die Barriereschicht enthält bei einer nächsten Weiterbildung beispielsweise Wolfram, Titan oder Tantal, d.h. Metalle mit einem Schmelzpunkt größer als 1600°C. Bei einer Ausgestaltung wird auch eine Nitridschicht eines solchen Metalls eingesetzt. Diese Barriereschichten sind als Diffusionssperre und Haftvermittlungsschichten besonders geeignet.

Die zusätzlich auf die Barriereschicht aufgebrachte Grenzelektrodenschicht besteht bei einer Weiterbildung aus Aluminium oder einer Aluminiumlegierung, die z.B. mehr als 90 Gewichts-% oder mehr als 95 Gewichts-% Aluminium enthält, d.h. aus einem prozesstechnisch gut zu bearbeitenden Material.

Bei einer nächsten Weiterbildung ist das galvanisch abgeschiedene Metall Kupfer, Gold, Silber oder Platin. Es werden auch Metalllegierungen mit mehreren dieser Stoffe eingesetzt.

Bei einer anderen Weiterbildung hat das Kontaktloch einen Durchmesser größer als 1 $\mu$m (Mikrometer) größer als 10 $\mu$m oder sogar größer als 20 $\mu$m. Die Schichtdicke der abgeschiedenen Schicht ist bei einer Ausgestaltung größer als 100 nm (Nanometer) oder größer als 500 nm oder sogar größer als 10 $\mu$m, wenn ein Verfahren mit Außenstrom zum Galvanisieren genutzt wird. Aber auch Kontaktlöcher mit einem Durchmesser kleiner als 1 $\mu$m lassen sich gut mit einem außenstromlosen Verfahren herstellen, ggf. in Kombination mit einem Außenstromverfahren.

Die Erfindung betrifft außerdem eine Verwendung eines erfindungsgemäßen Verfahrens zum Herstellen eines integrierten Leistungs-Schaltkreises, durch den beim Schalten Ströme größer als 1 A (Ampere), größer als 10 A oder sogar größer als 100 A fließen. Insbesondere bei Verwendung von außenstromlosen Galvanisierungsverfahren lassen sich elektrische Verbindungen mit sehr geringem elektrischen Widerstand und hoher Beständigkeit gegen Elektromigration herstellen, wie sie für derart hohe Ströme erforderlich sind.

Bei einer anderen Verwendung der erfindungsgemäßen Verfahren dienen die Verfahren zur Herstellung einer Vielzahl von Trägerschaltkreisen und zur Herstellung einer Vielzahl von getragenen Schaltkreisen. Eine Vielzahl ist beispielsweise eine Produktionsmenge von mehreren 1000 Schaltkreisen. Ein getragener Schaltkreis wird auf einem Trägerschaltkreis mit Hilfe einer Plättchen-Schnellmontagetechnik aufgebracht. Diese Technik wird auch als Flip-Chip-Technik bezeichnet. Beispielsweise werden die beiden Schaltkreise verlötet, so dass ihre aktiven Seiten einander zugewandt sind. Alternativ lassen sich auch andere Befestigungsverfahren der Flip-Chip-Technik verwenden.

Die Erfindung betrifft außerdem eine integrierte Schaltungsanordnung mit einem Kontaktloch, das ein Metall oder eine Metallverbindung enthält, deren Atome in Silizium einen großen Diffusionskoeffizienten haben. Das Metall oder die Metallverbindung hat eine Kristallgitterhomogenität, wie sie nur bei einem außenstromlosen galvanischen Abscheideverfahren entsteht. Damit sind die elektrischen Eigenschaften des Kontaktes im Vergleich zu Kontakten erheblich besser, die gesputtert oder mit Hilfe einer äußeren Strom- bzw. Spannungsquelle galvanisch hergestellt worden sind.

Im Folgenden werden Ausgestaltungen der Erfindung an Hand der beiliegenden Zeichnungen erläutert. Darin zeigen:

Figuren 1A bis 1C    Herstellungsstufen bei der Herstellung einer Kupfermetallisierung gemäß einer ersten Verfahrensvariante mit einer Aluminium-Keimbildungsschicht,

Figuren 2A bis 2C    Herstellungsstufen bei der Herstellung einer Kupfermetallisierung gemäß einer zweiten Verfahrensvariante mit einer Barriereschicht als Keimbildungsschicht, und

Figur 3    eine in Flip-Chip-Technik hergestellte integrierte Schaltungsanordnung.

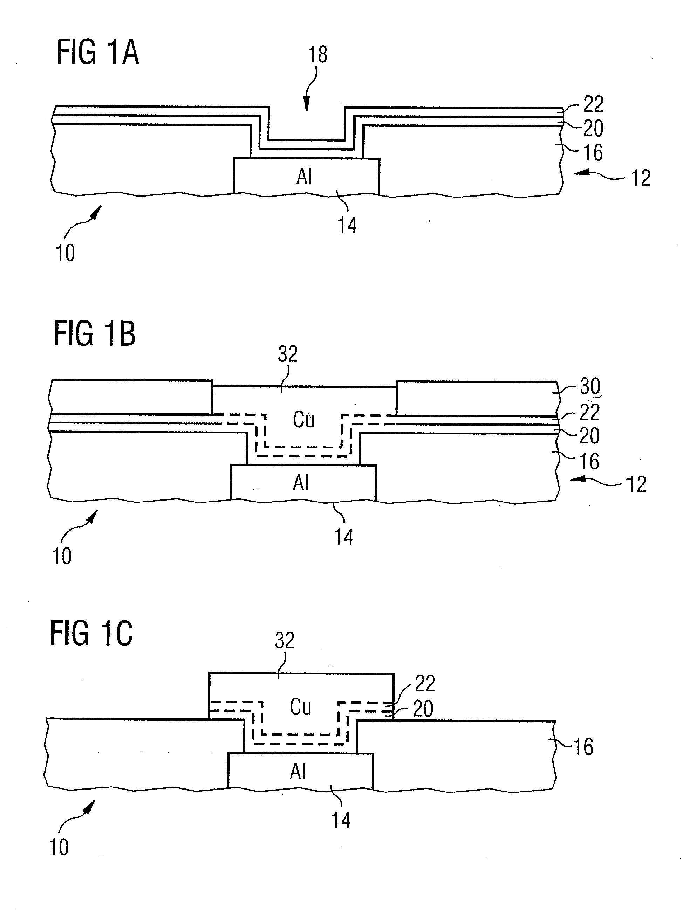

Figuren 1A bis 1C zeigen Herstellungsstufen der letzten Metallisierungslage einer integrierte Schaltungsanordnung 10 gemäß einer ersten Verfahrensvariante. Die integrierte Schaltungsanordnung 10 enthält bereits mindestens eine Metallisierungslage 12, in der eine Vielzahl von Aluminiumleitbahnen angeordnet sind, beispielsweise eine Leitbahn 14. Nach dem Herstellen der Metallisierungslage 12 wurde eine Isolierschicht 16 abgeschieden, beispielsweise aus Siliziumdioxid oder aus einem BPSG-Material (Borphosphorsilikatglas).

Mit Hilfe eines fotolithografischen Verfahrens wurden danach eine Vielzahl von Kontaktlöchern, d.h. von sogenannten Vias, in der Isolierschicht 16 erzeugt, beispielsweise ein Kontaktloch 18, das zu der Leitbahn 14 führt.

Anschließend wurde eine Barriereschicht 20 abgeschieden, die beispielsweise aus Wolframtitan WTi oder aus Nickel Ni besteht. Die Barriereschicht 20 wurde beispielsweise mit Hilfe eines Sputterverfahrens aufgebracht und hat eine Dicke unter 100 nm (Nanometer).

Danach wurde eine Aluminium-Keimbildungsschicht 22 aufgebracht, beispielsweise mit Hilfe eines Sputterverfahrens. Die Aluminium-Keimbildungsschicht 22 besteht aus Aluminium Al und hat im Ausführungsbeispiel eine Dicke von beispielsweise 50 nm. Bei anderen Ausführungsbeispielen ist die Dicke der Keimbildungsschicht 22 ebenfalls kleiner als 100 nm.

Wie in Figur 1B dargestellt, wird anschließend eine Fotolackschicht 30 aufgebracht, die beispielsweise eine Dicke von 30 $\mu$m (Mikrometer) oder eine größere Dicke hat. Die Fotolackschicht 30 wird gemäß vorgegebener Maskenstrukturen belichtet und entwickelt, wobei sich Anlagen nutzen lassen, die nicht mit Kupfer kontaminiert sind und auch nicht mit Kupfer kontaminiert werden.

Nach dem Strukturieren der Fotolackschicht 30 wird ein außenstromloses Galvanisierungsverfahren unter Verwendung einer Kupfersulfatlösung $CuSO_4$ durchgeführt. Dabei scheidet sich ein Kupferkontakt 32 im Kontaktloch 18 und oberhalb des Kontaktlochs 18 ab. Während des Galvanisierens wird die Aluminium-Keimbildungsschicht 22 im Bereich des Kontaktlochs 18 zersetzt. Die Barriereschicht 20 wird nur in einer oberen Teilschicht zersetzt, so dass sie ihre Funktion als Diffusionssperre noch in ausreichendem Maße erfüllt.

Beim Beenden des außenstromlosen Verfahrens ragt der Kupferkontakt 32 nicht oder nur etwas in den unteren Teil der in der Fotolackschicht 30 enthaltenen Aussparung. Ist das Kontaktloch 18 am Ende des außenstromlosen Verfahrens bereits gefüllt, wird das Galvanisieren beendet. Ist das Kontaktloch 18 dagegen am Ende des außenstromlosen Verfahrens noch nicht gefüllt, oder soll der Kupferkontakt weiter über die Isolierschicht 16 hinausragen, so wird ein Verfahren mit Außenstrom zum weiteren Galvanisieren verwendet. Alternativ wird auch nur mit einem Außenstromverfahren galvanisiert.

Wie in Figur 1C dargestellt, werden anschließend die Reste der Fotolackschicht 30 entfernt. Danach wird mit einem nasschemischen Ätzverfahren oder mit einem Trockenätzverfahren die Aluminium-Keimbildungsschicht 22 in Bereichen entfernt, die nicht vom Kupferkontakt 32 bedeckt sind. Ebenfalls mit einem nass-chemischen Ätzverfahren oder mit einem Trockenätzverfahren wird die Barriereschicht 20 in Bereichen entfernt, die nicht von den Kupferkontakten, z.B. vom Kupferkontakt 32, bedeckt sind.

Das an Hand der Figuren 1A bis 1C erläuterte Verfahren lässt sich mit einer vergleichsweise dünnen Barriereschicht 20 durchführen. Dies erleichtert die Prozessführung. Beispielsweise haftet eine dünne Barriereschicht besser als eine dickere Barriereschicht.

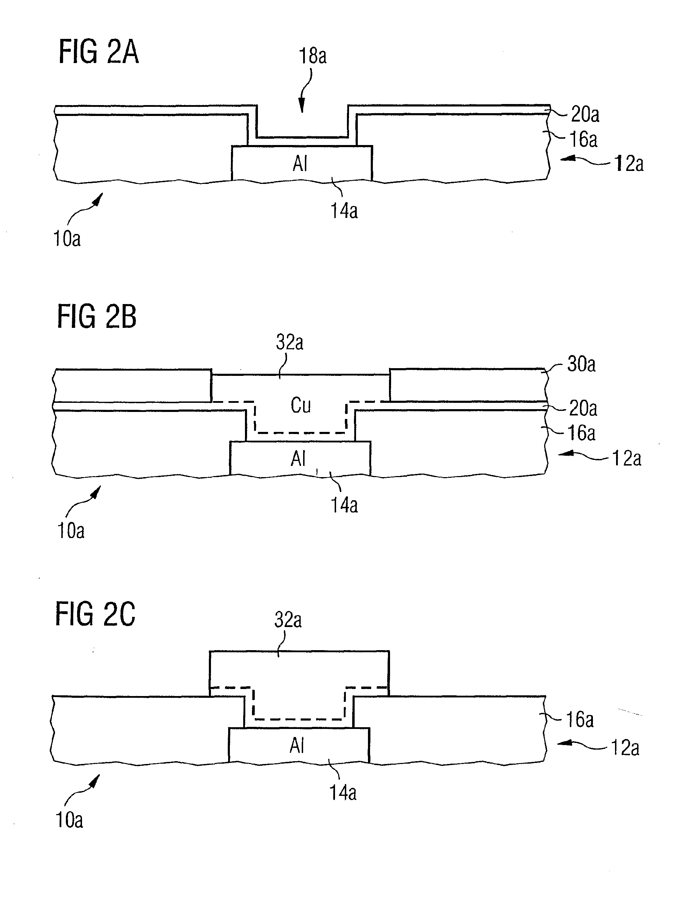

Die Figuren 2A bis 2C zeigen Herstellungsstufen bei der Herstellung einer Kupfermetallisierung direkt auf einer Barriereschicht. Wie in Figur 2A dargestellt, enthält eine integrierte Schaltungsanordnung 10a eine Metallisierungslage 12a. Die Metallisierungslage 12a enthält eine Leitbahn 14a aus Aluminium. Auf die Metallisierungslage 12a wurde eine Isolierschicht 16a aufgebracht, die aus dem gleichen Material, wie die Isolierschicht 16 besteht. Danach wurde die Isolierschicht 16a mit Hilfe eines fotolithografischen Verfahrens strukturiert, wobei ein Kontaktloch 18a oberhalb der Leitbahn 14a erzeugt worden ist.

Anschließend wurde eine Barriereschicht 20a aufgebracht, die beispielsweise aus einer Doppelschicht Titan Ti und Titannitrid TiN besteht. Die Dicke der Barriereschicht 20a wurde so gewählt, dass Zugspannungen nicht zu stark werden und dass andererseits aber auch eine ausreichend dicke Schicht vorhanden ist nach einer teilweisen Zersetzung der Barriereschicht 20a in einem außenstromlosen galvanischen Verfahren.

Wie in Figur 2B dargestellt, wurde anschließend eine Fotolackschicht 30a auf die Barriereschicht 20a aufgebracht. Die Fotolackschicht 30a hat beispielsweise wieder eine Dicke von 30 $\mu$m. Die Fotolackschicht 30a wurde dann in einem fotolithografischen Verfahren belichtet und entwickelt, wobei wiederum Anlagen eingesetzt werden, die nicht mit Kupfer kontaminiert sind und auch nicht mit Kupfer kontaminiert werden.

Anschließend wird bspw. mit Hilfe eines außenstromlosen Galvanisierungsverfahrens ein Kupferkontakt 32a aus Kupfer Cu im Bereich des Kontaktlochs 18a erzeugt. Während des Galvanisierens zersetzt sich eine obere Teilschicht der Barriereschicht 20a, siehe gestrichelte Linie 50.

Wie in Figur 2C dargestellt, werden anschließend die Reste der Fotolackschicht 30a entfernt, beispielsweise durch einen nasschemischen Reinigungsschritt. In einem nass-chemischen Ätzprozess wird danach die Barriereschicht 20a in Bereichen entfernt, die nicht vom Kupferkontakt 32a bedeckt sind.

Alternativ wird auch bei dem an Hand der Figuren 2A bis 2C erläuterten Verfahren nur ein galvanisches Verfahren mit Außenstrom oder ein kombiniertes Verfahren eingesetzt.

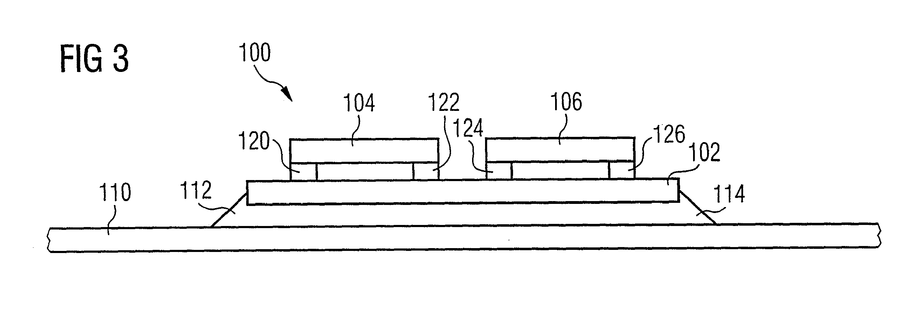

Figur 3 zeigt eine Anordnung 100 aus einem integrierten Prozessorschaltkreis 102 und aus zwei integrierten Speicherschaltkreisen 104 und 106. Die Anordnung 100 ist auf einer Leiterplatte 110 angeordnet, wobei Anschlussdrähte 112 und 114 vom Prozessorschaltkreis 102 zur Leiterplatte 110 führen.

Die integrierten Schaltungsanordnungen 102 bis 106 sind mit dem an Hand der Figuren 1A bis 1C bzw. mit dem an Hand der Figuren 2A bis 2C erläuterten Verfahren hergestellt worden. Nach der Herstellung der integrierten Schaltkreise 102 bis 106 wurden die beiden Speicherschaltkreise 104 und 106 in einer sogenannten Plättchen-Schnellmontage-Technik (Flip-Chip Technik) mit dem Prozessorschaltkreis 102 verlötet, siehe Lötstellen 120 bis 126. Alternativ lässt sich eine Klebetechnik einsetzen. Die aktiven Seiten der Speicherschaltkreise 104 und 106 sind der aktiven Seite des Prozessorschaltkreises 102 zugewandt.

Die in Figur 3 dargestellte Anordnung lässt sich nur dann rentabel in großer Zahl herstellen, wenn zur Herstellung der integrierten Schaltkreise 102 bis 106 das erfindungsgemäße Verfahren eingesetzt wird. Bei anderen Verfahren wäre die Kontamination von Anlagen nicht mehr vertretbar.

Die oben erläuterte Prozessführung hat folgende Vorteile:

- Aluminiumbearbeitungsverfahren sind Standardprozesse im BEOL,
- es lassen sich vorhandene Anlage und Prozesse uneingeschränkt nutzen,
- eine Dedizierung von Belichtungsanlagen ist nicht notwendig,
- geringe Kosten,
- eine klare Trennung von FEOL zu BEOL,
- keine Kontaminationsgefahr, und
- höhere Flexibilität und Modularität.

**Patentansprüche**

1. Verfahren zum Aufbringen von Metall (32, 32a),
   bei dem ohne Beschränkung durch die angegebene Reihenfolge die folgenden Verfahrensschritte ausgeführt werden:

   Erzeugen eines Kontaktlochs (18, 18a) zu einer Leitbahn (14, 14a) in einer Isolierschicht (16, 16a) einer integrierten Schaltungsanordnung (10, 10a),
   Aufbringen einer Barriereschicht (20, 20a) nach dem Erzeugen des Kontaktlochs (18, 18a),
   Aufbringen eines Metalls (32, 32a) oder einer Metalllegierung mit Hilfe eines galvanischen Verfahrens,

   wobei die Barriereschicht (20a) als Grenzelektrode in dem galvanischen Verfahren zum Aufbringen des Metalls oder der Metalllegierung dient,
   oder wobei zusätzlich zur Barriereschicht (20) vor dem Aufbringen der strahlungsempfindlichen Schicht (30) eine Grenzelektrodenschicht (22) aufgebracht wird, die aus einem Material mit einer anderen Materialzusammensetzung als die Barriereschicht (20) besteht,
   wobei eine für das galvanische Verfahren verwendete Lösung Kupferionen enthält,
   wobei die Lösung frei von einem Reduktionsmittel ist.

2. Verfahren nach Anspruch 1 **gekennzeichnet durch** die Schritte:

   Aufbringen einer strahlungsempfindlichen Schicht (30, 30a) nach dem Aufbringen der Barriereschicht (20, 20a),
   Bestrahlen der strahlungsempfindlichen Schicht (30, 30a) gemäß einem Muster,
   Entwickeln der strahlungsempfindlichen Schicht (30, 30a) nach dem Bestrahlen,
   nach dem Aufbringen des Metalls (32, 32a) Entfernen von Resten der strahlungsempfindlichen Schicht (30, 30a).

3. Verfahren nach Anspruch 1 oder 2, **dadurch gekennzeichnet, dass** die Atome des Metalls in Silizium einen großen Diffusionskoeffizienten haben,
   oder dass in der Metalllegierung mehr als 5 % der Atome in Silizium einen großen Diffusionskoeffizienten haben.

4. Verfahren nach einem der Ansprüche 1 bis 3, **dadurch gekennzeichnet, dass** das galvanische Verfahren unter Verwendung einer äußeren Strom- oder Spannungsquelle durchgeführt wird.

5. Verfahren nach einem der Ansprüche 1 bis 3, **dadurch gekennzeichnet, dass** das galvanische Verfahren außenstromlos durchgeführt wird.

6. Verfahren nach einem der vorhergehenden Ansprüche, **dadurch gekennzeichnet, dass** die Lösung auf Basis von Wasser, Alkohol, Ether oder einem Gemisch aus diesen Stoffen hergestellt wird.

7. Verfahren nach Anspruch 6, **dadurch gekennzeichnet, dass** die Lösung frei von Stoffen ist, die eine Ausfällung des Metalls ohne Vorhandensein eines Potentialunterschiedes an einer Grenzelektrode bewirken, insbesondere frei von Katalysatoren,
und dass die Elektrolytlösung frei von einem Reduktionsmittel ist, insbesondere frei von Formaldehyd.

8. Verfahren nach einem der vorhergehenden Ansprüche, **dadurch gekennzeichnet, dass** die Grenzelektrodenschicht während des galvanischen Verfahrens vollständig oder bis zu einer Teilschicht zersetzt wird,
und/oder dass die Barriereschicht (20, 20a) in einer Teilschicht während des galvanischen Verfahrens zersetzt wird.

9. Verfahren nach einem der vorhergehenden Ansprüche, **dadurch gekennzeichnet, dass** nach dem Entfernen der strahlungsempfindlichen Schicht ein Ätzvorgang durchgeführt wird, bei dem die Barriereschicht (20, 20a) gemäß der entstandenen Metallstrukturen geätzt wird,
vorzugsweise in einem nass-chemischen Ätzprozess und/oder ohne Durchführung eines weiteren lithografischen Verfahrens.

10. Verfahren nach einem der vorhergehenden Ansprüche, **dadurch gekennzeichnet, dass** die Leitbahn (14, 14a) aus Aluminium oder aus einer Aluminiumlegierung besteht.

11. Verfahren nach einem der vorhergehenden Ansprüche, **dadurch gekennzeichnet, dass** die Barriereschicht (20, 20a) ein Metall mit einem Schmelzpunkt größer als 1600 °C enthält,
und/oder dass die Barriereschicht (20, 20a) ein Metall enthält, dessen Atome in Silizium einen kleinen Diffusionskoeffizienten haben,
und/oder dass die Barriereschicht (20, 20a) ein Nitrid enthält, vorzugsweise ein Metallnitrid, oder dass die Barriereschicht aus einem Nitrid besteht, vorzugsweise aus einem Metallnitrid,
und/oder dass die Barriereschicht (20, 20a) einen oder mehrer der Stoffe Wolfram, Nickel, Tantal, Tantalnitrid, Titan oder Titannitrid enthält,
und/oder dass die Grenzelektrodenschicht (22) aus Aluminium oder aus einer Aluminiumlegierung besteht.

12. Verfahren nach einem der vorhergehenden Ansprüche, **dadurch gekennzeichnet, dass** das Metall Kupfer, Gold, Silber oder Platin ist,
oder dass die Metalllegierung mindestens einen dieser Stoffe zu mehr als 40 Gewichtsprozent enthält.

13. Verfahren nach einem der vorhergehenden Ansprüche, **dadurch gekennzeichnet, dass** das Kontaktloch (18) einen Durchmesser größer als 1 $\mu$m oder größer als 10 $\mu$m oder größer als 20 $\mu$m hat,
und/oder dass die Schichtdicke der galvanischen Schicht größer als 100 nm, größer als 500 nm oder größer als 1 $\mu$m ist.

14. Verfahren nach einem der vorhergehenden Ansprüche, **dadurch gekennzeichnet, dass** der Diffusionskoeffizient der Atome des Metalls oder von Atomen der Metalllegierung in Silizium bei 400°C größer als $10^{-12}$ cm$^2$/s oder größer als $10^{-10}$ cm$^2$/s größer als $10^{-9}$ cm$^2$/s ist.

15. Verwendung des Verfahrens nach einem der vorhergehenden Ansprüche zum Herstellen einer integrierten Schaltungsanordnung, die Ströme größer als 1 A, größer als 10 A oder größer als 100 A schaltet,
und/oder Verwendung des Verfahrens zum Herstellen einer Vielzahl von Trägerschaltkreisen (102) und getragenen Schaltkreisen (104, 106), wobei jeweils mindestens ein getragener Schaltkreis (104, 106) auf einem Trägerschaltkreis (102) angeordnet wird und wobei Seiten mit aktiven Bauelementen einander zugeordnet sind, insbesondere unter Verwendung einer Plättchen-Schnellmontage-Technik, vorzugsweise durch Verlöten des getragenen Schaltkreises (104, 106) und des Trägerschaltkreises (102).

16. Integrierte Schaltungsanordnung (10, 10a), insbesondere mit einem Verfahren nach einem der vorhergehenden Ansprüche hergestellte integrierte Schaltungsanordnung (10, 10a),
mit einem Kontaktloch (18, 18a), das mit einem Metall oder einer Metalllegierung gefüllt ist,
**dadurch gekennzeichnet, dass** das Metall oder die Metalllegierung vollständig oder innerhalb einer Teilschicht eine Kristallgitterhomogenität hat, wie sie bei einem außenstromlosen galvanischen Abscheideverfahren entsteht.

## FIG 1A

18

22
20
16
12

Al

10

14

## FIG 1B

32

30
Cu

22
20
16
12

Al

10

14

## FIG 1C

32

22
Cu
20

16

Al

10

14

## FIG 2A

18a

20a
16a
12a

Al

14a

10a

## FIG 2B

32a

30a

Cu

20a
16a
12a

Al

14a

10a

## FIG 2C

32a

16a

12a

Al

14a

10a

FIG 3

Europäisches
Patentamt

European
Patent Office

Office européen
des brevets

**EUROPÄISCHER TEILRECHERCHENBERICHT**

der nach Regel 63 des Europäischen Patentübereinkommens für das weitere Verfahren als
europäischer Recherchenbericht gilt

**Nummer der Anmeldung**

EP 09 17 0565

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (IPC) |
|---|---|---|---|
| X | US 5 587 337 A (IDAKA TOSHIAKI [JP] ET AL) 24. Dezember 1996 (1996-12-24) * Spalte 4, Zeile 45 - Spalte 5, Zeile 37 * ----- | 1-4,9-10 | INV. H01L21/768 |
| Y | US 6 249 055 B1 (DUBIN VALERY) 19. Juni 2001 (2001-06-19) * das ganze Dokument * ----- | 1-15 | |
| Y | US 5 151 168 A (TUTTLE MARK E ET AL) 29. September 1992 (1992-09-29) * das ganze Dokument * ----- | 1-15 | |
| Y | US 5 824 599 A (TING CHIU H ET AL) 20. Oktober 1998 (1998-10-20) * Zusammenfassung * ----- | 8 | |

**RECHERCHIERTE SACHGEBIETE (IPC)**

H01L

## UNVOLLSTÄNDIGE RECHERCHE

Die Recherchenabteilung ist der Auffassung, daß ein oder mehrere Ansprüche, den Vorschriften des EPÜ in einem solchen Umfang nicht entspricht bzw. entsprechen, daß sinnvolle Ermittlungen über den Stand der Technik für diese Ansprüche nicht, bzw. nur teilweise, möglich sind.

Vollständig recherchierte Patentansprüche:

Unvollständig recherchierte Patentansprüche:

Nicht recherchierte Patentansprüche:

Grund für die Beschränkung der Recherche:

Siehe Ergänzungsblatt C

| Recherchenort | Abschlußdatum der Recherche | Prüfer |
|---|---|---|
| München | 20. Oktober 2009 | Boetticher, Harald |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

............................................................
& : Mitglied der gleichen Patentfamilie, übereinstimmendes
Dokument

EPO FORM 1503 03.82 (P04E09)

Europäisches
Patentamt

European
Patent Office

Office européen
des brevets

**UNVOLLSTÄNDIGE RECHERCHE
ERGÄNZUNGSBLATT C**

Nummer der Anmeldung

EP 09 17 0565

Vollständig recherchierbare Ansprüche:
-

Unvollständig recherchierte Ansprüche:
1-15

Nicht recherchierte Ansprüche:
16

Grund für die Beschränkung der Recherche:

In Anspruch 1 ist der Zweck der Kupferionen klar für Kupfer-Abscheidung, nicht aber, wenn Gold, Platin oder Silber (siehe Anspruch 12) aufgebracht werden soll; Seite 8 Zeilen 27 bis 36 scheint nur eine Kupfer-Abscheidung zu stützen. - Auch ist "wobei die Lösung frei von einem Reduktionsmittel ist" vage: Wie ein Reduktionsmittel zu ersetzen ist, ist aus den Ansprüchen oder der Beschreibung nicht erkennbar. - Bei einer Grenzelektroden-Schicht auf einer Barriereschicht ist in Anspruch 1 nun jedes Material zulässig, auch eines mit hohem Diffusionskoeffizienten in Silizium, z.B. Kupfer; wegen Verstoßes gegen Art. 76(1) wurde diese Alternative nicht recherchiert. - Anspruch 16 steht wegen "außenstromlosen" im Widerspruch zu "Grenzelektrode" in Anspruch 1. Der Recherchenbericht ist aus diesen Gründen unvollständig; eine Recherche aller Merkmale der abhängigen Ansprüche war dadurch nicht sinnvoll.

**ANHANG ZUM EUROPÄISCHEN RECHERCHENBERICHT
ÜBER DIE EUROPÄISCHE PATENTANMELDUNG NR.**

EP 09 17 0565

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-10-2009

| Im Recherchenbericht angeführtes Patentdokument | Datum der Veröffentlichung | Mitglied(er) der Patentfamilie | Datum der Veröffentlichung |
|---|---|---|---|
| US 5587337 A | 24-12-1996 | KEINE | |
| US 6249055 B1 | 19-06-2001 | KEINE | |
| US 5151168 A | 29-09-1992 | KEINE | |
| US 5824599 A | 20-10-1998 | KEINE | |

EPO FORM P0461

Für nähere Einzelheiten zu diesem Anhang : siehe Amtsblatt des Europäischen Patentamts, Nr.12/82